Europäisches Patentamt

European Patent Office

Office européen des brevets

(19)

(11) Veröffentlichungsnummer: **0 197 917**

**A2**

(12) **EUROPÄISCHE PATENTANMELDUNG**

(21) Anmeldenummer: **86890084.6**

(22) Anmeldetag: **01.04.86**

(51) Int. Cl.⁴: **G01N 15/06 , G01N 21/27 ,**
**G01R 17/02 , G01J 1/16**

(30) Priorität: **04.04.85 AT 1028/85**

(43) Veröffentlichungstag der Anmeldung:
**15.10.86 Patentblatt 86/42**

(84) Benannte Vertragsstaaten:
**DE FR GB IT**

(71) Anmelder: **AVL GESELLSCHAFT FÜR**
**VERBRENNUNGSKRAFTMASCHINEN UND**
**MESSTECHNIK MBH.PROF.DR.DR.H.C.HANS**
**LIST**
**Kleiststrasse 48**
**A-8020 Graz(AT)**

(72) Erfinder: **Faschingleitner, Leopold**
**Anzenbach 5**
**A-3240 Mank(AT)**
Erfinder: **Krempl, Peter W., Dr.**
**Stiftingtalstrasse 71/4/12**
**A-8010 Graz(AT)**
Erfinder: **Schindler, Wolfgang, Dr.**
**Mariatroster Strasse 113**
**A-8043 Graz(AT)**

(74) Vertreter: **Krause, Walter Dr. Dipl.-Ing. et al**
**Singerstrasse 8**
**A-1010 Wien(AT)**

(54) Verfahren zur periodischen Bestimmung einer Messgrösse sowie Einrichtung zur Durchführung dieses Verfahrens.

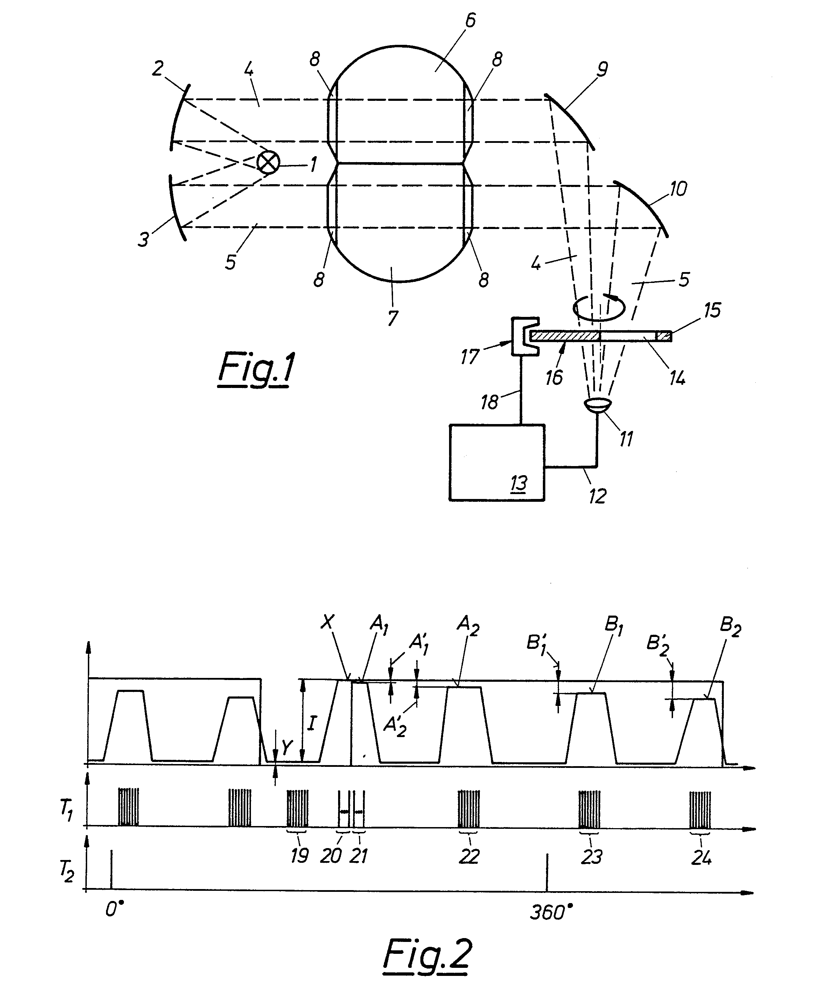

(57) Um apparativ bedingte Schwankungen bei der periodischen Bestimmung einer Meßgröße durch Differenzbildung zwischen einem durch die zu messende Größe gegenüber einem Ursprungssignal veränderten Meßsignal und einem durch die zu messende Größe gegenüber dem Ursprungssignal unbeeinflußten Referenzsignal auszuschalten, wird für jede Bestimmung der Meßgröße ein Grundsignalpegel (I) als Differenz zwischen dem Referenzpegel (X) und einem Nullpegel (Y) bei fehlendem Ursprungssignal bestimmt und dann sowohl jeder aktuelle Referenzsignalpegel (A) als auch jeder Meßsignalpegel (B) mit dem zuerst gemessenen Referenzsignalpegel (X) kompensiert. Durch Verstärkung der kompensierten Referenzsignale (A') und Meßsignale (B') vor der Differenzbildung und Normierung der aus diesen Signalen gebildeten Differenz (E) auf den Grundsignalpegel (I) kann eine hohe Genauigkeit auch bei nur geringen Abschwächungen des Meßsignals durch die zu messende Größe erreicht werden (Fig. 2).

Fig.2

Verfahren zur periodischen Bestimmung einer Meßgröße sowie Einrichtung zur Durchführung dieses Verfahrens

Die Erfindung betrifft ein Verfahren zur periodischen Bestimmung einer Meßgröße, insbesondere zur kontinuierlichen Messung der Masse von Aerosolteilchen in gasförmigen Proben, wobei für jede Bestimmung der Meßgröße zumindest je ein durch die zu messende Größe gegenüber einem Ursprungssignal verändertes Meßsignal und ein durch die zu messende Größe gegenüber dem Ursprungssignal unbeeinflußtes Referenzsignal gemessen, die Differenz zwischen diesen Signalen gebildet und aus der Differenz auf die Meßgröße geschlossen wird, sowie eine Einrichtung zur Durchführung dieses Verfahrens.

Derartige Meßverfahren bzw. Einrichtungen sind in verschiedensten Zusammenhängen bekannt; so behandelt beispielsweise die AT-PS 376 301 ein Verfahren der genannten Art zur kontinuierlichen Messung der Masse von Aerosolteilchen in gasförmigen Proben, insbesonders im Auspuffgas von Brennkraftmaschinen, wobei neben einem die Probe enthaltenden Prüfvolumen auch ein Vergleichsvolumen mit elektromagnetischer Strahlung von bestimmter Wellenlänge durchstrahlt und die Differenz der Strahlungsintensitäten nach Durchgang durch die beiden Volumina der gesuchten Meßgröße zugeordnet wird.

Nachteile ergeben sich in diesem Zusammenhang insbesondere dann, wenn die zum Schluß auf die Meßgröße dienende Differenz zwischen dem Referenzsignal und dem Meßsignal sehr klein ist, da dann die bei der periodischen Bestimmung der Meßgröße auszunutzenden Schwankungen des Differenzsignals selbst naturgemäß noch kleiner sind und ohne weiteres bereits in der Größenordnung von apparativ bedingten Schwankungen, beispielsweise der Intensität des Ursprungssignals oder des Wirkungsgrades eines Detektors, leigen können, was sinnvolle, genaue Messungen unmöglich macht und beispielsweise auch zu Übersteuerungen von Verstärkern für das Differenzsignal führen kann.

Beim bereits zitierten Beispiel der Messung der Beladung des Auspuffgases einer Brennkraftmaschine mit Aerosolpartikeln muß mit Absorptionen unter 1 %. gereichnet werden, wenn Partikelbeladungen von 1 mg/m³ und darunter gemessen werden sollen, was im Hinblick auf die Tatsache, daß sowohl die Quellintensität des Ursprungssignals als auch die Detektorempfindlichkeit Schwankungen bis zu 10 % aufweisen können, Schwierigkeiten bei der Durchführung von genauen und signifikanten Messungen macht.

Aufgabe der vorliegenden Erfindung ist es, ein Verfahren der eingangs genannten Art bzw. eine zugehörige Einrichtung so zu verbessern, daß zumindest weitgehend unabhängig von apparativ bedingten Schwankungen auch kleine Änderungen der zu bestimmenden Meßgröße genau und signifikant erfaßbar sind.

Dies wird gemäß der vorliegenden Erfindung dadurch erreicht, daß für jede Bestimmung der Meßgröße ein Grundsignalpegel als Differenz zwischen dem Referenzsignalpegel und einem Nullpegel bei fehlendem Ursprungssignal bestimmt wird, daß der aktuelle Referenzsignalpegel nochmals bestimmt und mit dem zuerst gemessenen Referenzsignalpegel kompensiert wird, daß der Meßsignalpegal bestimmt und ebenfalls mit dem zuerst gemessenen Referenz signalpegel kompensiert wird, daß das so kompensierte Referenzsignal und Meßsignal in gleichem Maße verstärkt werden, daß sodann die Differenz der verstärkten, kompensierten Signale gebildet wird, und daß diese Differenz unter Berücksichtigung des Grundsignalpegels zum Schluß auf die Meßgröße dient. Durch die für einzelne Bestimmung der Meßgröße erfolgende Bestimmung des Grundsignalpegels werden apparativ bedingte, nicht von der zu bestimmenden Meßgröße verursachte Schwankungen im Ursprungssignal -also beispielsweise Schwankungen der Quellintensität -sowie auch -durch die Nullpegelbestimmung -Schwankungen in der Nachweisempfindlichkeit von einer Einflußnahme auf die jeweilige Bestimmung der Meßgröße ausgeschlossen. Der dann für die Messung verwendete aktuelle Referenzsignalpegel, der im Idealfall -also ohne die genannten apparativen Schwankungen - dem zuerst bestimmten Referenzsignalpegel gleichen müßte, wird ebenso wie der von der zu messenden Größe veränderte Meßsignalpegel mit dem zuerst gemessenen Referenzsignalpegel kompensiert, sodaß vorerst auf die jeweils aktuelle Stärke des Ursprungssignals bezogene kompensierte Signale erhalten werden. Nach einer zur Erhöhung der Genauigkeit durchgeführten Verstärkung wird die Differenz der verstärkten, kompensierten Signale gebildet, die unter Berücksichtigung des oben beschriebenen Grundsignalpegels zum Schluß auf die Meßgröße dient.

Auf diese Weise können apparativ bedingte Schwankungen wirksam berücksichtigt und signifikante Messungen auch bei sehr kleinen Signaldifferenzen durchgeführt werden.

Gemäß einer weiteren Ausgestaltung der Erfindung kann zur Berücksichtigung des Grundsignalpegels die Differenz der kompensierten und verstärkten Signale durch den Grundsignalpegel dividiert und das so normierte Signal jeweils der gesuchten Meßgröße zugeordnet werden. Dies ist eine sehr einfache Art der Berücksichtigung des - schwankenden Grundsignalpegels im bereits kompensierten und verstärk ten Differenzsignal, die sich auch apparativ leicht verwirklichen läßt.

Gemäß einer besonders bevorzugten Ausgestaltung der Erfindung ist vorgesehen, daß der Grad der Verstärkung der kompensierten Signale zumindest annähernd reziprok zum Grad der Abschwächung des Meßsignals gegenüber dem Ursprungssignal ist. Damit kann die Differenz der kompensierten Signale mit ähnlicher Genauigkeit wie der Grundsignalpegel, der eine Maß für die jeweils relevante Stärke des Ursprungssignals ist, bestimmt werden, was aber nur möglich ist im Zusammenhang mit der beschriebenen dynamischen Kompensation der gemessenen Signal für jede Bestimmung der Meßgröße, da ohne diese die apparativen Schwankungen berücksichtigende Kompensation bzw. bei Ersetzen der dynamischen Kompensation durch eine Kompensation mit einem fixen Wert praktisch laufend Übersteuerung des Verstärkers auftreten würde.

Bei einer Einrichtung zur Durchführung des erfindungsgemäßen Verfahrens zur Absorptionsmessung an gasförmigen Proben, mit einer Strahlungsquelle, einem die Probe enthaltenden Prüfvolumen und einem von nachzuweisenden Stoffen freien Vergleichsvolumen, welche beide von der Strahlungsquelle durchstrahlt sind, und mit einem Detektor, dem über eine Auswahleinrichtung abwechselnd zumindest ein Meßsignal vom Prüfvolumen und ein Referenzsignal vom Vergleichsvolumen zuführbar ist, sowie mit einer mit dem Detektor verbundenen Auswerteeinrichtung zur Bildung der Differenz der zugehörigen Signale und Zuordnung zur gesuchten Meßgröße -wie sie beispielsweise ebenfalls aus der eingangs bereits genannten AT-PS 376 301 bekannt ist -ist gemäß einer weiteren Ausbildung der Erfindung vorgesehen, daß die Auswerteeinrichtung einen über eine Kompensiereinrichtung und einen nachgeschalteten Verstärker mit dem Detektor in Verbindung stehenden A/D-Konverter zur Bestimmung der Signalintensitäten aufweist, daß weiters ein über einen Zwischenspeicher mit dem A/D-Konverter verbundener D/A-Konverter vorgesehen ist, der jeweils aus dem zuerst gemessenen Referenzsignalpegel eine Kompensationsspannung erzeugt und mit seinem Ausgang mit einem Eingang der Kompensiereinrichtung verbunden ist, und daß der Ausgang des A/D-Konverters mit einem Eingang eines Mikroprozessors der Auswerteeinrichtung in Verbindung steht. Dies ist eine sehr einfache Ausgestaltung der Einrichtung zur periodischen Bestimmung einer Meßgröße mittels des erfindungsgemäßen Verfahrens, mit der auch mit hohen Meßfrequenzen gearbeitet und genau gemessen werden kann.

Um große Signalhübe zu vermeiden und die Genauigkeit zu erhöhen, ist gemäß einer weiteren Ausgestaltung der Erfindung eine Speichereinheit vorgesehen, die zwischen Detektorausgang und Kompensiereinrichtung eingeschaltet ist und während des Umschaltens der Auswahleinrichtung jeweils den letzten Signalpegel hält.

Um den Aufbau der gesamten Einrichtung und insbesonders der Auswerteeinrichtung zu vereinfachen bzw. kostengünstiger zu machen, kann die Kompensiereinrichtung samt nachgeschaltetem Verstärker nach einer weiteren Ausgestaltung der Erfindung von einem programmierbaren Instrumentenverstärker gebildet sein.

Gemäß einer anderen bevorzugten Weiterbildung der Erfindung umfaßt die Auswerteeinrichtung eine Zeitablaufsteuereinheit, die mit der Auswahleinrichtung verbunden ist und abhängig von deren aktueller Auswahlstellung über Ausgangsleitungen Steuersignale an die anderen Komponenten der Auswerteeinrichtung abgibt. Damit ist auf einfache Weise eine genaue zeitliche Synchronisation der Aufnahme und Verarbeitung der einzelnen Signale möglich.

Die Erfindung wird im folgenden anhand der in der Zeichnung teilweise schematisch dargestellten Ausführungsbeispiele näher erläutert.

Figur 1 zeigt eine Einrichtung zur Durchführung des erfindungsgemäßen Verfahrens zur Absorptionsmessung an gasförmigen Proben,

Figur 2 zeigt ein Diagramm mit dem Verlauf des bereits vorverstärkten Detektorsignals aufgetragen über der Zeit bzw. über dem Drehwinkel der Auswahleinrichtung, wie er mit einer Einrichtung nach Figur 1 erhalten und erfindungsgemäß zur periodischen Bestimmung der Meßgröße verwendet wird und

Figur 3 zeigt eine andere Einrichtung nach der vorliegenden Erfindung mit genauerer - schematischer Darstellung der Auswerteeinrichtung.

Die Einrichtung nach Fig. 1 dient zur periodischen Messung beispielsweise der Masse von Aerosolteilchen im Auspuffgas von Brennkraftmaschinen. Von einer Strahlungsquelle 1 wird elektromagnetische Strahlung im Infrarotbereich abgegeben, die nach Reflexion an zwei Hohlspiegeln 2, 3 in zwei Teilstrahlen 4, 5 jeweils ein Vergleichsvolumen 6 und ein Prüfvolumen 7 über strahlungsdurchlässige Fenster 89 durchsetzt. Nach Reflexion an zwei weiteren Hohlspiegeln 9, 10 werden die Teilstrahlen 4,5 auf einen gemeinsamen Detektor 11 fokusiert, der über eine Leitung 12 mit einer Auswerteeinrichtung 13 in Verbindung steht. Im Strahlengang beider Teilstrahlen 4, 5 vor dem Detektor ist eine, hier als mit Ausnehmungen bzw. Filtern 14 versehenes Chopperrad 15 ausgeführte, Auswahleinrichtung 16 angeordnet, die - zufolge kontrollierter Drehung des Chopperrades 15 -in bestimmter zeitlicher Aufeinanderfolge abwechselnd zumindest ein Meßsignal (Teilstrahl 5) vom Prüfvolumen 7 und ein Referenzsignal (Teilstrahl 4) vom Vergleichsvolumen 6 zum gemeinsamen Detektor 11 durchläßt. Eine Lichtschranke 17 ist über eine Leitung 18 mit einer hier nicht separat dargestellten Zeitablaufsteuereinheit in der Auswerteeinrichtung 13 verbunden und ermöglicht beispiels weise im Zusammenhang mit den in der Spur $T_1$ des Diagrammes nach Fig. 2 eingetragenen, am Umfang des Chopperrades 15 aufgebrachten Triggermarken eine genaue zeitliche Synchronisation der Aufnahme und Verarbeitung der einzelnen Signale.

Anhand des Diagrammes nach Fig. 2 wird nun im folgenden die periodische Bestimmung einer Meßgröße mit der Einrichtung nach Fig. 1 näher erläutert.

Vorweg ist hier darauf hinzuweisen, daß der in Fig. 2 oben eingezeichnete Signalverlauf dem über die Leitung 12 gelieferten, gegebenenfalls bereits vorverstärkten oder sonst aufbereiteten Detektorsignal entspricht, wobei hier bei jedem Meßzyklus - also jeder Umdrehung des Chopperrades 15 -dem Detektor 11 vier von der zu messenden Größe unterschiedlich beeinflußte Signalpegel zugeführt werden -daß also abgesehen von für die verwendete Strahlung überhaupt undurchlässigen Bereichen zwei Filter bzw. Ausnehmungen 14 am Chopperrad vorgesehen sind. Davon abgesehen ist es natürlich auch möglich, mehrere Ausnehmungen bzw. Filter 14 am Chopperrad 15 entsprechend versetzt anzuordnen, sodaß die Teilstrahlen 4, 5 jeweils abwechselnd durchgelassen werden. Auf alle Fälle werden hier in jedem Meßzyklus zwei Referenzsignalpegel $A_1$ und $A_2$ bei verschiedenen Wellenlängen -realisiert durch unterschiedliche Filter 14 -sowie zwei Meßsignalpegel $B_1$ und $B_2$ bei jeweils zum zugehörigen Referenzsignalpegel gleicher Wellenlänge bestimmt; die einzelnen Striche auf der Triggerspur $T_1$ bedeuten die einzelnen Messungen des Detektorsignals -hier sind für die Bestimmung jedes Signalpegels acht Einzelmessungen vorgesehen, über die gemittelt wird.

Am Beginn jedes Meßzyklus wird vorerst ein Nullpegel Y bei fehlendem Ursprungssignal bestimmt -die zugehörigen Einzelmessungen sind auf der Triggerspur $T_1$ mit 19 bezeichnet -sodann wird ein Referenzsignalpegel X durch Mittelung über die Einzelmessungen 20 bestimmt, was hier bei der gleichen Stellung der Auswahleinrichtung 16 wie zur Bestimmung des nachfolgenden aktuellen Referenzsignalpegels $A_1$ geschieht.

Aus dem Referenzsignalpegel X und dem Nullpegel Y wird ein Grundsignalpegel I = X-Y ermittelt, der -wie unten stehend noch angesprochen - bei der endgültigen Bestimmung der Meßgröße zur Berücksichtigung apparativer Schwankungen dient.

Sodann wird im Bereich 21 der Triggerspur $T_1$ der aktuelle Referenzsignalpegel $A_1$ nochmals bestimmt und mit dem zuerst gemessenen Referenzsignalpegel X = I+Y kompensiert, was hier beispielsweise zufolge von bereichsweise unterschiedlicher Filterdichte ein kompensiertes Referenzsignal $A_1$'ergibt. Als nächstes wird sodann im Bereich 22 der Triggerspur $T_1$ der zweite aktuelle Referenzsignalpegel $A_2$ bestimmt und ebenfalls mit dem zuerst gemessenen Referenzsignalpegel X kompensiert, was ein kompensiertes zweites Referenzsignal $A_2$ ergibt. Der Vollständigkeit halber sei hier darauf hingewiesen, daß die Messung der Referenzsignalpegel $A_1$ und $A_2$ am Teilstrahl 4 aus Fig. 1 erfolgt, der das Vergleichsvolumen 6 durchsetzt, in dem Referenzgas -beispielsweise reine Luft -enthalten ist, womit diese Signalpegel von der zu messenden Größe gegenüber dem Ursprungssignal unbeeinflußt sind.

Im Bereich 23 der Triggerspur $T_1$ wird der wellenlängenmäßig zum Referenzsignalpegel $A_1$ bzw. kompensierten Referenzsignalpegel $A_1$'gehörige Meßsignalpegel $B_1$ bestimmt, der nun zufolge Messung des das Prüfvolumen durchsetzenden Teilstrahls 5 von der zu messenden Größe gegenüber dem Ursprungssignal charakteristisch abgeschwächt ist. Auch dieser wird wiederum mit dem zuerst gemessenen Referenzsignal X kompensiert, was zum kompensierten Meßsignal $B_1$'führt. Im Bereich 24 wird so dann noch der zum Referenzsignalpegel $A_2$ bzw. kompensierten Referenzsignalpegel $A_2$ gehörige zweite Meßsignalpegel $B_2$ bestimmt und wider mit dem zuerst gemessenen Referenzsignalpegel X kompensiert, was das kompensierte Meßsignal $B_2$'liefert. Die Signalaufnahme beginnt sodann für den nächsten Meßzyklus wieder von vorne -die in Fig. 2 oben links eingezeichneten beiden ersten Signalzachen sind die den Meßsignalpegeln $B_1$ und $B_2$ entsprechenden des vorherigen Meßzyklus.

Der Vollständigkeit halber ist auch auf den Verlauf des Kompensationssignalpegels hinzuweisen, der im Diagramm der Fig. 2 oben eingezeichnet ist und für jeden kompletten Meßzyklus jeweils gleichbleibend dem zuerst gemessenen Referenzsignalpegel X entspricht. In der Triggerspur $T_2$ in Fig. 2 sind schließlich die Winkelmarken 0° und 360° eingetragen, um im Hinblick auf die Drehung des Chopperrades 15 die Länge eines Meßzyklus anzugeben.

Prinzipiell kann das Verfahren auch mit nur einem aktuellen Referenzsignalpegel A und einem Meßsignalpegel B für jeden Meßzyklus durchgeführt werden -mit der hier dargestellten und besprochenen Variante sind eigentlich für jeden Meßzyklus -also jede Umdrehung des Chopperrades 15 -zwei voneinander praktisch unabhängige Meß werte -entsprechend unterschiedlichen Absorptionen bei den verschiedenen Frequenzen -zu erhalten.

Die kompensierten Referenzsignale $A_1'$ und $A_2'$ und die kompensierten Meßsignale $B_1'$ und $B_2'$ werden in der Auswerteeinrichtung 13 (siehe Fig. 1) in gleichem Maße verstärkt, wobei der Grad der Verstärkung zumindest annähernd reziprok zum Grad der Abschwächung der Meßsignale gegenüber dem Ursprungssignal gewählt wird, um für die Differenzsignale eine ähnliche Genauigkeit wie für die Bestimmung des Grundsignalpegels I zu erhalten. Sodann wird noch auf hier nicht weiter illustrierte Weise eine Differenz $E_1 = A_1' - B_1'$ bzw. $E_2 = A_2' - B_2'$ gebil det, welche nach Berücksichtigung des Grundsignalpegels I beispielsweise durch Division von $E_1$ bzw. $E_2$ durch I unmittelbar zum Schluß auf die gesuchte Meßgröße bzw. die gesuchten Meßgrößen dienen kann.

Da also, wie beschrieben, der zur Kompensation dienende zuerst gemessene Referenzsignalpegel X während eine Meßzyklus konstant gehalten wird -siehe Fig. 2 -sind also alle Referenzwerte und Meßwerte jedes Meßzyklus auf den gleichen, apparativ Schwankungen berücksichtigenden Pegel bezogen, wodurch Meßfehler zufolge apparativ bedingter Schwankungen ausgeschaltet werden und sehr genaue und signifikante Messungen auch bei durch die zu messende Größe nur geringfügig abgeschwächten Signalen möglich sind.

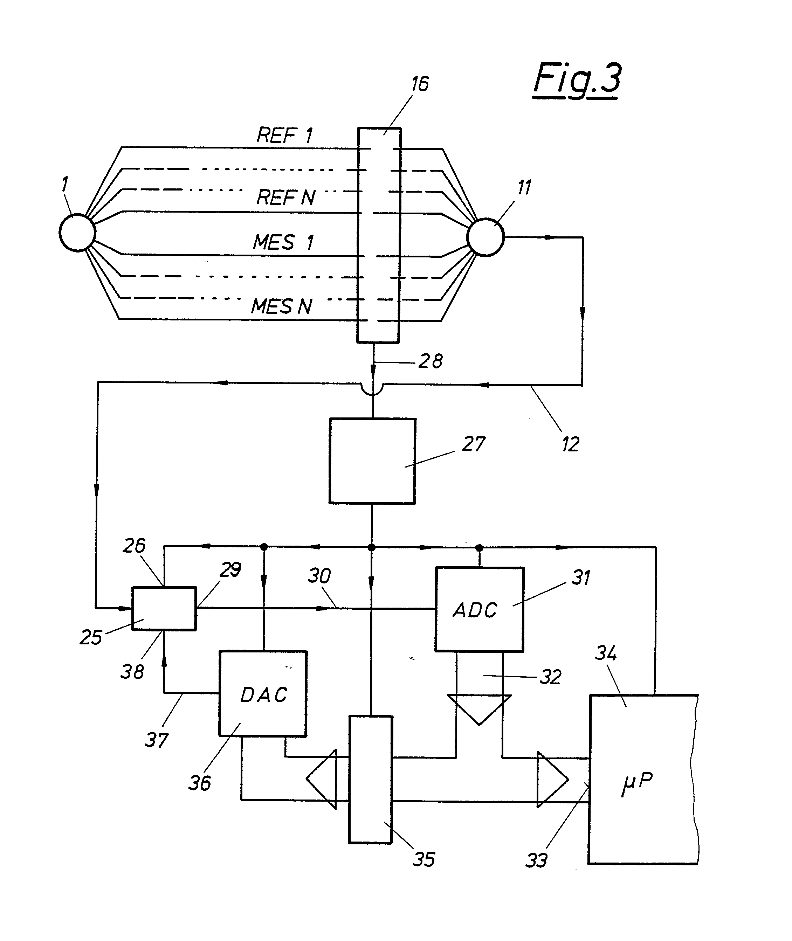

Bei der in Fig. 3 dargestellten Einrichtung is wiederum eine einzelne Strahlungsquelle 1 und eine einzelner Detektor 11 vorgesehen; die zwischen diesen möglichen Signalwege sind was die unbeeinflußten Referenzsignale betrifft mit REF 1 bis REF N und was die von der zu messenden Größe gegenüber dem Ursprungssignal veränderten Meßsignale betrifft mit MES 1 bis MES N bezeichnet. Zur Durchschaltung nur jeweils eines einzelnen der möglichen Wege ist auch hier wiederum eine Auswahleinrichtung 16 vorgesehen, wofür ein Multiplexer an sich beliebiger Ausführung dienen kann.

Der Detektor 11 ist über die Leitung 12 mit einer Kompensiereinrichtung samt nachgeschaltetem Verstärker -mit 25 bezeichnet -verbunden, welche über einen Eingang 26 auch mit einer Zeitablaufsteuereinheit 27 in Verbindung steht, die ihrerseits über eine Leitung 28 Information über die aktuelle Stellung der Auswahleinrichtung 16 erhält. Der Verstärkerausgang 29 der kombinierten Einheit 25 ist über eine Leitung 30 mit einem A/D-Konverter 31 verbunden, mittels welchem jeweils die Signalintensitäten bestimmt und digitalisiert werden.

Der A/D-Konverter 31 ist über eine Dateleitung 32 einerseits mit dem Eingang 33 eines Mikroprozessors 34 und andererseits -über einen Zwischenspeicher 35 -mit einem D/A-Konverter 36 verbunden, der jeweils aus dem zuerst gemessenen Referenzsignalpegel (X in Fig. 2) eine Kompensationsspannung erzeugt, die über eine Leitung 37 an einem Eingang 38 Kompensiereinrichtung in der Einheit 25 liegt.

Der Vollständigkeit halber ist hier auch darauf hinzuweisen, daß abgesehen von dert Einheit 25 auch die beiden Konverter 31,36, der Zwischenspeicher 35 und der Mikroprozessor 34 über entsprechende Leitungen mit der Zeitablaufsteuereinheit 27 in Verbindung stehen, die abhängig von der aktuellen Auswahlstellung der Auswahleinrichtung 16 Steuersignale an diese Komponenten zur Synchronisation der Signalaufnahme bzw. Verarbeitung abgibt.

Die Einheit 25 aus Kompensiereinrichtung und Verstärker kann beispielsweise von einem programmierbaren Instrumentenverstärker gebildet sein, was die Einstellung verschiedener Verstärkungsgrade für die einzelnen aufgenommenden Signale (siehe die Beschreibung zu Fig. 2) ermöglicht.

Zwischen dem Ausgang des Detektors 11 und dem Eingang der Kompensiereinrichtung könnte auch eine hier nicht dargestellte Speichereinheit vorgesehen sein, die während des Umschaltens der Auswahleinrichtung 16 jeweils den letzten Signalpegel hält, womit große Signalhübe -wie in Fig. 2 eingezeichnet -vermieden werden können und die Genauigkeit verbessert wird.

## Ansprüche

1. Verfahren zur periodischen Bestimmung einer Meßgröße, insbesondere zur kontinuierlichen Messung der Masse von Aerosolteilchen in gasförmigen Proben, wobei für jede Bestimmung der Meßgröße zumindest je ein durch die zu messende Größe gegenüber einem Ursprungsignal verändertes Meßsignal und ein durch die zu messende Größe gegenüber dem Ursprungsignal unbeeinflußtes Referenzsignal gemessen, die Differenz zwischen diesen Signalen gebildet, und aus der Differenz auf die Meßgröße geschlossen wird, dadurch gekennzeichnet, daß für jede Bestimmung der Meßgröße ein Grundsignalpegel (I) als Differenz zwischen dem Referenzsignalpegel (X) und einem Nullpegel (Y) bei fehlendem Ursprungsignal bestimmt wird, daß der aktuelle Referenzsignalpegel (A) nochmals bestimmt und mit dem zuerst gemessenen Referenzsignalpegel (X = I+Y) kompensiert wird, daß der Meßsignalpegel (B) bestimmt und ebenfalls mit dem zuerst gemessenen Referenzsignalpegel (X) kompensiert wird, daß das so kompensierte Referenzsignal (A' = A-X) und Meßsignal (B' = B-X) in gleichem Maße verstärkt werden, daß sodann die Differenz (E) der verstärkten, kompensierten Signale (E = A'-B') gebildet wird, und daß diese Differenz (E) unter Berücksichtigung des Grundsignalpegels (I) xzum Schluß auf die Meßgröße dient.

2. Verfahren nach Anspruch 1, dadurch gekennzeichnet daß zur Berücksichtigung des Grundsignalpegels (I) die Differenz (E) der kompensierten und verstärkten Signale (A',B') durch den Grundsignalpegel (I) dividiert wird und das so normierte Signal (E" = E/I) jeweils der gesuchten Meßgröße zugeordnet wird.

3. Verfahren nach Anspruch 1 oder 2, dadurch gekennzeichnet, daß der Grad der Verstärkung der kompensierten Signal (A',B') zumindest annähernd reziprok zum Grad der Abschwächung des Meßsignals gegenüber dem Ursprungsignal ist.

4. Einrichtung zur Durchführung des Verfahrens nach einem der Ansprüche 1 bis 3, zur Absorptionsmessung an gasförmigen Proben, mit einer Strahlungsquelle, einem die Probe enthaltenden Prüfvolumen und einem von nachzuweisenden Stoffen freien Vergleichsvolumen, welche beide von der Strahlungsquelle durchstrahlt sind, und mit einem Detektor, dem über eine Auswahleinrichtung abwechselnd zumindest ein Meßsignal vom Prüfvolumen und ein Referenzsignal vom Vergleichsvolumen zuführbar ist, sowie mit einer mit dem Detektor verbundenen Auswerteeinrichtung zur Bildung der Differenz der zugehörigen Signale und Zuordnung zur gesuchten Meßgröße, dadurch gekennzeichnet, daß die Auswerteeinrichtung (13) einen über eine Kompensiereinrichtung (25) und einen nachgeschalteten Verstärker mit dem Detektor (11) in Verbindung stehenden A/D-Konverter - (31) zur Bestimmung der Signalintensitäten aufweist, daß weiters ein über einen Zwischenspeicher (35) mit dem A/D-Konverter (31) verbundener D/A-Konverter (36) vorgesehen ist, der jeweils aus dem zuerst gemessenen Referenzsignalpegel (X) eine Kompensationsspannunge rzeugt und mit seinem Ausgang mit einen Eingang (38) der Kompensiereinrichtung (25) verbunden ist, und daß der Ausgang (32) des A/D-Konverters mit einem Eingang eines Mikroprozessors (34) der Auswerteeinrichtung in Verbindung steht.

5. Einrichtung nach Anspruch 4, dadurch gekennzeichnet, daß eine Speichereinheit vorgesehen ist, die zwischen Detektorausgang und Eingang der Kompensiereinrichtung eingeschaltet ist und während des Umschaltens der Auswahleinrichtung jeweils den letzten Signalpegel hält.

6. Einrichtung nach Anspruch 4 oder 5, dadurch gekennzeichnet, daß die Kompensiereinrichtung - (25) samt nachgeschaltetem Verstärker von einem programmierbaren Instrumentenverstärker gebildet ist.

7. Einrichtung nach einem der Ansprüche 4 bis 6, dadurch gekennzeichnet, daß die Auswerteeinrichtung eine Zeitablaufsteuereinheit (27) umfaßt, die mit der Auswahleinrichtung (16) verbunden ist und abhängig von deren aktueller Auswalstellung über Ausgangsleitungen Steuersignale an die anderen Komponenten (25, 31, 34, 35, 36) der Auswerteeinrichtungen abgibt.

0 197 917

_Fig.1_

_Fig.2_

0 197 917

Fig.3